# EUROPÄISCHE PATENTSCHRIFT

(11) **EP 4 149 216 B1**
(45) Veröffentlichungstag und Bekanntmachung des Hinweises auf die Patenterteilung: **17.06.2026**
(21) Anmeldenummer: 22191864.2
(22) Anmeldetag: 24.08.2022
(51) Int. Cl.: H05K 1/02, H05K 3/12, H05K 3/28, H05K 3/46, H05K 1/03, H05K 1/05, H05K 3/32, H05K 3/34, H05K 1/16, H05K 1/11, H05K 1/00

(54) **ELEKTRISCHES SCHALTUNGSBAUTEIL UND VERFAHREN ZUR HERSTELLUNG EINES ELEKTRISCHEN SCHALTUNGSBAUTEILS**
ELECTRICAL CIRCUIT COMPONENT AND METHOD FOR PRODUCING AN ELECTRICAL CIRCUIT COMPONENT
COMPOSANT DE CIRCUIT ÉLECTRIQUE ET PROCÉDÉ DE FABRICATION D'UN COMPOSANT DE CIRCUIT ÉLECTRIQUE

(30) Priorität: 13.09.2021 DE 102021210067
(43) Veröffentlichungstag der Anmeldung: 15.03.2023
(73) Patentinhaber: E.G.O. Elektro-Gerätebau GmbH, 75038 Oberderdingen (DE)
(72) Erfinder: Block, Volker, 75015 Bretten (DE); Köbrich, Holger, 76703 Kraichtal-Gochsheim (DE); Robin, Bernd, 76356 Weingarten (DE); Schmieder, Manuel, 75038 Oberderdingen (DE)
(74) Vertreter: Patentanwälte Ruff, Wilhelm, Beier, Dauster & Partner mbB

(56) Entgegenhaltungen:
- EP-A1- 0 963 143
- US-A- 3 495 133
- US-A- 3 887 760
- US-A- 5 056 215
- US-A- 5 220 200
- US-B2- 9 293 438

## Beschreibung

### Anwendungsgebiet und Stand der Technik

Die Erfindung betrifft ein elektrisches Schaltungsbauteil sowie ein Verfahren zur Herstellung eines solchen Schaltungsbauteils. Insbesondere ist das Schaltungsbauteil vorteilhaft eine Heizeinrichtung, mit der besonders vorteilhaft Wasser erwärmt werden kann.

Aus der DE 100 44 441 A1 ist ein Verfahren bekannt, wie ein metallischer Anschluss an einen keramischen Träger angebracht werden kann. Dazu wird ein sogenanntes Aktivlot verwendet. Ähnliches beschreibt die EP 963 143 A1, aus der ebenfalls ein Aktivlot bekannt ist, welches Silber und eine reaktive Legierungskomponente mit hoher Sauerstoffaffinität enthalten kann.

Üblicherweise werden elektrische Anschlüsse an Kontaktbahnen mit Kontaktfeldern auf einem Träger durch Löten eines Anschlusses auf die Oberseite des Kontaktfelds hergestellt. Ein Teil des Kontaktfelds ist dann von dem Lot bedeckt, ein weiterer Teil möglicherweise auch von ausgehärtetem Flussmittel, das bekanntermaßen in dem Lot zum besseren Verlöten enthalten ist.

Aus der US 9,293,438 B2 ist ein elektrisches Schaltungsbauteil bekannt mit einer Platine, auf deren Oberseite elektrisch leitfähige Leiterbahnen verlaufen. Die sonstige Oberfläche der Platine ist mit einer Abdeckschicht bedeckt, welche zum Teil auch auf die Leiterbahnen überlappt. Auf der Oberseite der Leiterbahnen ist elektrisch leitfähiges Füllmaterial aufgebracht, welches von der Abdeckschicht nicht überdeckt wird, wobei die Abdeckschicht auf der Oberseite an Außenseiten des Füllmaterials heranreicht.

Aus der US 3,887,760 A ist ein Schaltungsbauteil bekannt mit Leiterbahnen auf einem Träger, die aus darauf aufgebrachten Kupferbahnen bestehen. An freien Enden der Leiterbahnen sind Kontaktfelder ausgebildet, an die Halbleiter-Bauteile angelötet werden zur elektrischen Kontaktierung und auch zur mechanischen Befestigung. Um die Anhäufung von zu viel Lötzinn an den freien Enden und den Kontaktfeldern zu vermeiden, werden kurz davor Brückenstücke als Glasschicht von zwei gegenüberliegenden Seiten an die Leiterbahnen aufgebracht. So erfolgt eine Abdeckung der lateralen Außenseiten der Leiterbahn und eine starke Verengung der Oberseitenfläche der Leiterbahn nahe dem Kontaktfeld.

Aus der US 5,220,200 A und der US 5,056,215 A ist ein elektrisches Schaltungsbauteil bekannt mit einem Bauteilträger und Leiterbahnen darauf. Leiterbahnen enden in einem rechteckigen Bereich mit einem freien Ende als Kontaktfelder. Hier können Kontakte bzw. Kontaktfüße eines IC-Bauteils angesetzt und aufgelötet werden. Barrieren für Lötzinn gegen dessen Abfließen sind im Bereich der freien Enden der Leiterbahnen bzw. der Kontaktfelder als glashaltige Beschichtung aufgebracht. Sie überlappen Teile der Leiterbahnen und Endseiten der Kontaktfelder.

Aus der US 3,495,133 A geht ein elektrisches Schaltungsbauteil hervor mit Leiterbahnen und freien Enden dieser Leiterbahnen, die Kontaktfelder bilden. An die Kontaktfelder können elektrische oder elektronische Bauteile angelötet werden. Material, das nicht von Lötzinn benetzt werden kann, wird kurz vor den Kontaktfeldern quer über die Leiterbahn auf deren Oberseite aufgebracht in einer Anordnung von zwei oder drei winklig zusammenhängenden Schenkeln.

### Aufgabe und Lösung

Der Erfindung liegt die Aufgabe zugrunde, ein eingangs genanntes elektrisches Schaltungsbauteil sowie ein Verfahren zur Herstellung eines solchen Schaltungsbauteils zu schaffen, mit denen Probleme des Standes der Technik gelöst werden können und es insbesondere möglich ist, eine hohe Korrosionsbeständigkeit zu erreichen, eine dauerhafte Funktionalität zu ermöglichen sowie den Herstellungsaufwand gering zu halten.

Gelöst wird diese Aufgabe durch ein elektrisches Schaltungsbauteil mit den Merkmalen des Anspruchs 1 sowie durch ein Verfahren zur Herstellung eines solchen Schaltungsbauteils mit den Merkmalen des Anspruchs 13. Vorteilhafte sowie bevorzugte Ausgestaltungen der Erfindung sind Gegenstand der weiteren Ansprüche und werden im Folgenden näher erläutert. Dabei werden manche der Merkmale nur für das elektrische Schaltungsbauteil oder nur für das Verfahren zu seiner Herstellung erläutert. Sie sollen jedoch unabhängig davon sowohl für ein solches elektrisches Schaltungsbauteil als auch für ein Verfahren zu seiner Herstellung selbstständig und unabhängig voneinander gelten können. Der Wortlaut der Ansprüche wird durch ausdrückliche Bezugnahme zum Inhalt der Beschreibung gemacht.

Es ist vorgesehen, dass das elektrische Schaltungsbauteil einen Träger aufweist, der eine Oberseite aufweist. Der Träger kann eben oder gewölbt sein, beispielsweise auch ein Rohr sein. Das Schaltungsbauteil weist eine Kontaktbahn und ein mit der Kontaktbahn verbundenes Kontaktfeld auf, die auf der Oberseite des Trägers angeordnet sind. Sie können mittels eines üblichen Verfahrens aufgebracht werden, eine mögliche Beschichtungstechnik ist ein Dickschichtverfahren, bevorzugt mit Siebdruck. Die Kontaktbahn und das Kontaktfeld sind vorteilhaft einstückig miteinander verbunden bzw. bestehen aus demselben Material und können auch in einem gemeinsamen Schritt und zusammen hergestellt werden. Das Kontaktfeld weist eine Oberseite und lateral umgebende Außenseiten auf. Im Idealfall weist das Kontaktfeld im Querschnitt einen rechteckigen Querschnitt auf mit vertikalen Außenseiten, die rechtwinklig zur Oberseite des Trägers stehen. In der Praxis wird dies bekanntermaßen nicht ganz erreicht, die Außenseiten können also nach unten zur Oberseite des Trägers hin etwas flach auslaufen bzw. abgerundet sein. Entsprechend können sie auch am Übergang in die Oberseite des Kontaktfelds abgerundet sein, möglicherweise auch insgesamt schräg zur Oberseite des Trägers stehen. Jedenfalls sind die Außenseiten bzw. die lateralen Außenseiten diejenigen Bereiche des Kontaktfelds, die freiliegen und die nicht die Oberseite des Kontaktfelds bilden, welche im Wesentlichen parallel ist zur Oberseite des Trägers. Auf der Oberseite des Trägers ist eine Beschichtung vorgesehen bzw. wird eine Beschichtung aufgebracht. Diese Beschichtung ist so aufgebracht, dass sie mindestens einen Teil der Oberseite des Trägers bedeckt, zusätzlich in vorteilhafter Weise auch mindestens einen Teil der Kontaktbahn.

Erfindungsgemäß reicht die Beschichtung entlang aller Außenseiten des Kontaktfelds mindestens an das Kontaktfeld heran, und somit bedeckt die Beschichtung das Kontaktfeld zumindest an den genannten Außenseiten, also lateral. Insbesondere bedeckt die Beschichtung die Außenseiten des Kontaktfelds derart, dass sie von dort einen geschlossenen Übergang zur Oberseite des Trägers bewirkt bzw. bildet. Somit sind die Außenseiten vollständig bedeckt und eingeschlossen. Damit sind sie auch luftdicht abgedeckt. Damit kann unter anderem das Problem gelöst werden, dass das Material des Kontaktfelds korrodiert oder mit Feuchtigkeit und Luftsauerstoff in Kontakt kommt und oxidiert. Eine weitere mögliche Folge kann es auch sein, wenn Gleichstrom oder Gleichstromanteile vorliegen mit einem Potenzialgefälle zwischen dem Kontaktfeld einerseits und einem anderen elektrischen Leiter auf der Oberseite des Trägers andererseits, dass Material bzw. Metallionen aus dem Kontaktfeld hin zu dem anderen Leiter abwandern. Diese Gefahr besteht insbesondere bei einem silberhaltigen Kontaktfeld mit Silberionen, die aus dem Kontaktfeld abwandern. Dadurch kann zum Einen eine Kriechstromfestigkeit des Schaltungsbauteils leiden. Zum Anderen kann an dem Kontaktfeld möglicherweise eine Silberverarmung stattfinden, welche dessen elektrischen Widerstand erhöht und möglicherweise derart stark verändert bzw. erhöht, dass die Funktion der Kontaktierung nicht mehr ausreichend gewährleistet ist. Dann kann es zu negativen Folgen wie einer starken Erwärmung am Kontaktfeld kommen. An den Außenseiten des Kontaktfelds können somit keine Korrosion, keine Oxidation und auch keine Verarmung von Metallionen bzw. Silberionen auftreten.

Auf der Oberseite des Kontaktfelds wird üblicherweise ein Anschluss angelötet, beispielsweise ein Anschluss in Stabform, Drahtform oder nach Art einer Anschlussfahne. Bei dieser Lötverbindung breitet sich das Lot über den direkten Verbindungsbereich zwischen Anschluss und Oberseite des Kontaktfelds auch etwas zur Seite hin aus. So kann das Lot zumindest einen Teil der Oberseite des Kontaktfelds bedecken und diese somit ebenfalls vor den vorgenannten Schäden bzw. Beeinträchtigungen schützen. Da es je nach Größe des Kontaktfelds und des Anschlusses in einigen Fällen nicht praktikabel sein wird, derart viel Lot zu verwenden, dass die gesamte Oberseite des Kontaktfelds immer davon bedeckt ist, kann ein Teil dieser Oberseite mit der Beschichtung bedeckt werden. Dabei bedeckt das Lot dann die gesamte Oberseite des Kontaktfelds bis an die an den Außenseiten oder Randbereichen vorgesehene Beschichtung heran. In einigen Fällen wird jedoch die Verwendung von derart viel Lot nicht praktikabel sein, zu teuer sein oder andere Probleme hervorrufen. Zwar kann möglicherweise auch aus dem Lot austretendes Flussmittel die restliche Oberseite des Kontaktfelds bis an die Beschichtung an den Außenseiten heran bedecken. Auch dies ist jedoch nicht sicher. Insofern kann es in vorteilhafter Weiterbildung der Erfindung vorgesehen sein, dass die Beschichtung mindestens entlang eines Teils einer Außenseite des Kontaktfelds, insbesondere entlang aller Außenseiten des Kontaktfelds, von außen auf die Oberseite des Kontaktfelds überlappt. So kann sie die Oberseite zumindest teilweise bedecken, insbesondere in einem Randbereich der Oberseite an die Außenseiten angrenzend. Wenn diese Bedeckung entlang aller Außenseiten geschlossen umläuft, so kann ein mittlerer bzw. zentraler Bereich der Oberseite des Kontaktfelds frei bleiben. Hier ist keine Beschichtung vorgesehen. Dies ist auch für das Anlöten des Anschlusses wichtig, da es nicht praktikabel wäre, wenn die Beschichtung in diesem Bereich dann erst wieder entfernt werden müsste. Dabei können mindestens 30 % der Oberseite des Kontaktfelds frei sein und keine Beschichtung aufweisen. Vorteilhaft sind dies mindestens 70 %, es können beispielsweise auch bis zu maximal 95 % der Oberseite des Kontaktfelds frei bleiben ohne Beschichtung, also ohne die lateralen Außenseiten gesehen. Der Randbereich kann zwischen 0,05 mm und 2 mm breit sein, vorteilhaft zwischen 0,1 mm und 1 mm breit sein.

In Weiterbildung der Erfindung ist es möglich, dass die Beschichtung entlang aller Außenseiten des Kontaktfelds nach oben auf dieses überlappt und dabei eine Art umlaufenden und nach oben stehenden Rand oder Randbereich bildet. Da dieser Rand vorteilhaft umlaufend geschlossen ist, kann so eine Begrenzung oder eine Art Wanne für sich auf der Oberseite des Kontaktfelds ausbreitendes flüssiges Lot bilden. So kann verhindert werden, dass dieses seitlich über das Kontaktfeld überläuft oder sich seitlich über dieses hinaus ausbreitet, was wiederum die Gefahr von Kurzschlüssen an andere Kontakte oder von unzureichender Kriechstromfestigkeit birgt. Ein Überstand der Beschichtung auf der Oberseite des Kontaktfelds nach oben kann im Wesentlichen der sonstigen Dicke der Beschichtung entsprechen. Allgemein kann die Beschichtung eine Dicke aufweisen, welche insbesondere in Richtung senkrecht zur Oberseite des Kontaktfelds und des Trägers gemessen wird, die mindestens 10% der Dicke des Kontaktfelds in derselben Richtung beträgt. Insbesondere kann die Beschichtung noch etwas dicker sein, beispielsweise mindestens 30% und bis zu 100% der Dicke des Kontaktfelds betragen.

Eine dickere Beschichtung ist bei üblicherweise vorgesehenen Dicken von Kontaktfeldern nicht praktikabel, würde zu viel Beschichtungsmaterial verbrauchen und wäre auch nur schwer zu realisieren, wenn sie das Kontaktfeld auch entlang der Randbereiche der Außenseiten überdecken sollte. Die Dicke der Beschichtung sowohl auf der Oberseite des Trägers als auch auf der Oberseite des Kontaktfelds kann allgemein zwischen 10 µm und 150 µm liegen, vorteilhaft zwischen 20 µm und 50 µm liegen. Vorteilhaft kann sie etwa 30 µm betragen.

In vorteilhafter Weiterbildung der Erfindung kann die Beschichtung auch die Kontaktbahn zumindest im Bereich des Übergangs von der Kontaktbahn an das Kontaktfeld bedecken. Da die Kontaktbahn üblicherweise aus demselben Material gebildet wird wie das Kochfeld, besteht auch hier die vorgenannte Problematik, so dass besonders vorteilhaft vorgesehen ist, dass die Kontaktbahn vollständig mit der Beschichtung bedeckt ist. Üblicherweise weist eine solche Kontaktbahn mindestens zwei Kontaktfelder auf bzw. verläuft zwischen mindestens zwei Kontaktfeldern, wobei vorgesehen sein kann, dass die Kontaktbahn an keiner Stelle freiliegt bzw. ohne Beschichtung ist. So kann insbesondere auch vermieden werden, dass Material des Kontaktfelds im Bereich des Übergangs an die Kontaktbahn freiliegt.

Bei der Erfindung ist die Beschichtung elektrisch isolierend, wobei sie Glas aufweist oder zu mindestens 50% aus Glas besteht. Sie kann so auch eine Dielektrikumsschicht bzw. eine Passivierungsschicht bilden für von ihr bedeckte Bereiche des Schaltungsbauteils. Die Beschichtung des Schaltungsbauteils bedeckt erfindungsgemäß auch weitere Kontaktbahnen und/oder weitere Kontaktfelder auf der Oberseite des Trägers zumindest teilweise. Dabei ist vorteilhaft vorgesehen, dass eine einzige Beschichtung sämtliche Bereiche überdeckt, an denen sie vorgesehen sein soll, vorteilhaft vollständig. Dazu kann sie möglicherweise einen komplexen oder komplizierten Verlauf aufweisen, der an das Vorhandensein von Kontaktfeldern bzw. Kontaktbahnen auf der Oberseite des Trägers angepasst ist. Wenn die Beschichtung aber mit einem vorgenannten Beschichtungsverfahren, beispielsweise Dickschichtverfahren, insbesondere Siebdruck, aufgebracht wird, stellt dies kein Problem dar.

Gleichzeitig wird es als vorteilhaft angesehen, wenn Bereiche der Oberseite des Trägers, die ohne Aufbau sind oder keine Bauteile, Kontaktbahnen odgl. tragen, im Wesentlichen freigelassen sind. So kann die insgesamt benötigte Menge an Beschichtungsmaterial reduziert werden. Dabei wird es als vorteilhaft angesehen, wenn die Beschichtung die vorgenannten Teile, insbesondere Kontaktfelder und Kontaktbahnen, in seitlicher Richtung noch zu mindestens 1 mm auf die Oberseite des Trägers hinunter bedeckt. So ist deren Beschichtung bzw. Verschluss auf alle Fälle sichergestellt.

In weiterer Ausgestaltung der Erfindung können auf der Oberseite des Trägers Heizleiter angeordnet sein. Diese sind bevorzugt auch als Beschichtung aufgebracht, beispielsweise durch ein vorgenanntes Dickschichtverfahren, insbesondere Siebdruck. Diese Heizleiter, insbesondere auch die vorgenannte Kontaktbahn bzw. das Kontaktfeld an die Heizleiter, können silberhaltig sein, um ein entsprechendes Widerstandsverhalten für eine gewünschte Heizwirkung zu erreichen. Dann sind vorteilhaft auch die Heizleiter von der Beschichtung bedeckt. Neben den vorgenannten Vorteilen gegen Korrosion bzw. Oxidation weist dies noch den Vorteil auf, dass dann auch aus den Heizleitern keine Metallionen bzw. Silberionen abwandern können.

Ein elektrischer Anschluss an das Kontaktfeld erfolgt vorteilhaft über einen vorgenannten Anschluss, der mit Lot angelötet ist oder angeschweißt sein kann. Bei dem fertigen Anschluss ist dann das Kontaktfeld vollständig bedeckt, und zwar von dem Anschluss, von dem Lot an der Oberseite, ggf. Flussmittel aus dem Lot und mit der Beschichtung entlang der Außenseiten. Vorteilhaft ist das Kontaktfeld ausschließlich mit Anschluss, Lot und Beschichtung bedeckt und abgedeckt, so dass nicht versucht werden muss, einen Teil der Oberfläche ausschließlich mit Flussmittel alleine zu bedecken. Dies kann unter anderem dadurch erreicht werden, dass die Beschichtung an die Außenseiten des Kontaktfelds angrenzend auf den vorgenannten Randbereich auf der Oberseite des Kontaktfelds überlappt. Somit ist auch dieser Randbereich von der Beschichtung bedeckt. Der Randbereich kann eine Breite von mindestens 0,5 mm aufweisen, vorteilhaft mehrere Millimeter bis zu 2 mm oder 3 mm breit sein. Dies hängt von der Größe des Kontaktfelds ab, wobei diese üblicherweise nicht allzu groß ausgebildet sind, um auch Material für das Kontaktfeld einzusparen. So kann beispielsweise ein Kontaktfeld 3 mm breit und 5 mm lang sein, wobei die Beschichtung an den Randbereichen mit einer Breite von etwa 0,5 mm auf die Oberseite überlappt. Dann ist ein Bereich von etwa 2 mm x 4 mm frei, um den Anschluss anzulöten, wofür natürlich eine freie Oberseite des Kontaktfelds benötigt wird. Gleichzeitig kann bei diesen Abmessungen davon ausgegangen werden, dass das zum Löten verwendete Lot die von der Beschichtung freigelassene Oberseite des Kontaktfelds vollständig bedeckt und dabei bis an die Beschichtung heranreicht. So ist das Kontaktfeld vollständig geschlossen bedeckt. Die Höhe bzw. Dicke des Kontaktfelds selbst kann allgemein zwischen 10 µm und 150 µm liegen, vorteilhaft kann sie zwischen 15 µm und 50 µm liegen.

Die Beschichtung sollte in einem einzigen Schritt und vollflächig auf das Schaltungsbauteil bzw. auf den Träger des Schaltungsbauteils aufgebracht werden. Dabei werden eben darauf vorhandene Kontaktbahnen und Kontaktfelder zumindest teilweise bedeckt, beispielsweise überdruckt. Die Kontaktbahnen werden vorteilhaft vollständig überdruckt, und bei den Kontaktfeldern kann wie innerhalb einer Art von Rahmen ein Bereich freigelassen werden für das Anlöten eines Anschlusses. Das zum Anlöten verwendete Lot wird dann flüssig und die noch freigelassene Oberseite des Kontaktfelds bedecken und so sowohl den Anschluss elektrisch anschließen und mechanisch befestigen als auch gemeinsam mit der Beschichtung das Kontaktfeld vollständig bedecken. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine stark vergrößerte Draufsicht auf ein Kontaktfeld samt Kontaktbahn mit einer teilweisen Überdeckung durch eine Beschichtung, wobei das Kontaktfeld in der Mitte freigelassen ist,
- Fig. 2: eine Draufsicht auf einen Bereich einer Heizeinrichtung als erfindungsgemäßes Schaltungsbauteil mit Kontaktbahnen in Kontaktfeldern sowie Heizleitern,
- Fig. 3: eine Schnittdarstellung durch die Anordnung aus Fig. 1, bei der die aufgebrachte Beschichtung an den Außenseiten und auf einem Randbereich des Kontaktfelds ist, und
- Fig. 4: eine Schnittdarstellung ähnlich Fig. 3 in Vergrößerung mit angelötetem Anschluss.

### Detaillierte Beschreibung der Ausführungsbeispiele

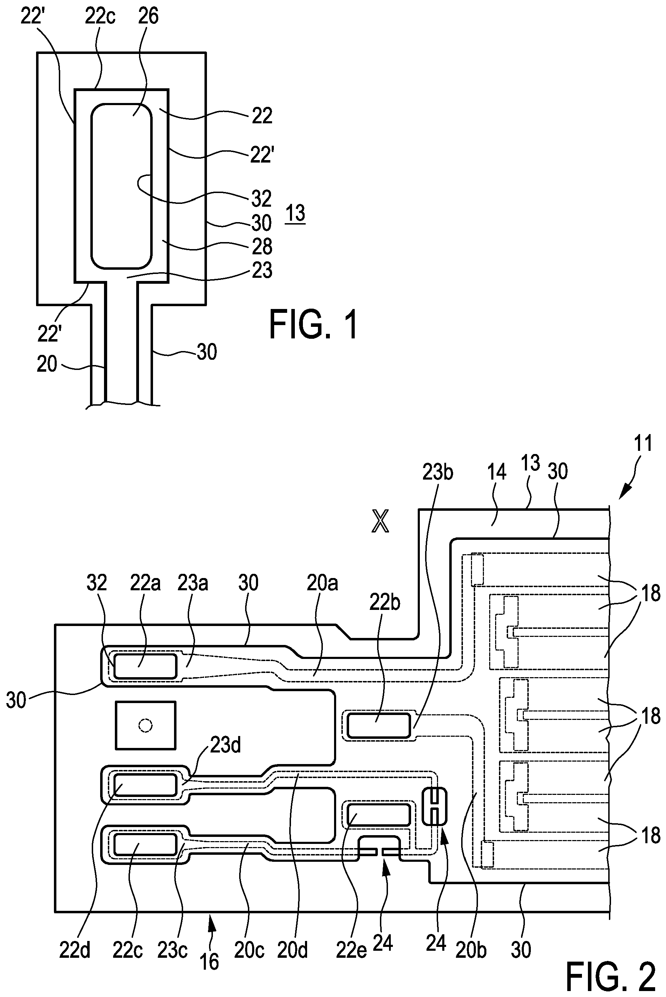

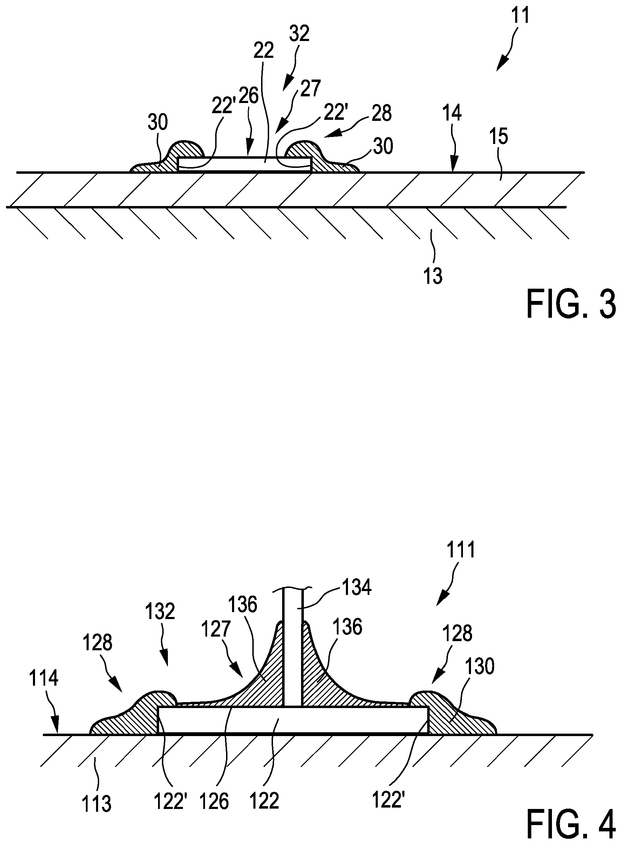

In der Fig. 1 ist in Draufsicht eine Vergrößerung auf ein Kontaktfeld 22 samt davon abgehender Kontaktbahn 20 dargestellt, wobei das Kontaktfeld 22 auf bekannte Art und Weise etwas breiter ist als die Kontaktbahn 20 selbst. Beide bestehen aus dem gleichen Material und sind in einem einzigen Arbeitsschritt auf einen nachfolgend noch näher beschriebenen Träger aufgebracht, vorteilhaft durch ein Dickschichtverfahren wie Siebdruck. Sie weisen eine hohe elektrische Leitfähigkeit auf für einen möglichst geringen Widerstand, da es ja elektrische Anschlüsse sind, insbesondere um Leistungen im Bereich von bis zu 1 kW oder bis zu 3 kW zu übertragen. Dazu weist das Material vorteilhaft Silber auf, insbesondere mit einem geringen Anteil, wie dies an sich bekannt ist, da Silber eine sehr hohe Leitfähigkeit aufweist. Die Kontaktbahn 20 und das Kontaktfeld 22 weisen gleiche Dicke auf. Aus der Schnittdarstellung der Fig. 3 ist zu ersehen, dass ihr Querschnitt hier angenähert rechteckig dargestellt ist. In der Praxis sind Außenseiten 22' zumindest beim Kontaktfeld 22 etwas schräg, und nach unten zu einer Oberseite 14 eines Trägers 13 verlaufen sie etwas abgerundet nach außen. Zu einer Oberseite 26 des Kontaktfelds 22 hin sind sie ebenfalls etwas abgerundet, und zwar nach innen. Am Übergangsbereich 23 vom Kontaktfeld 22 zur Kontaktbahn 20 sollte ebenfalls die gleiche Dicke vorliegen. Dieser Übergangsbereich 23 kann auch allmählich verlaufend ausgebildet sein, also mit gleichmäßig abnehmender Breite.

Wie aus Fig. 1 zu erkennen ist, sind Kontaktfeld 22 und Kontaktbahn 20 von einer Beschichtung 30 überdeckt. Die Beschichtung 30 überlappt seitlich an der Kontaktbahn 20 und an den Außenseiten 22' des Kontaktfelds 22 ein Stück bis auf die Oberseite 14 des Trägers 13. Diese Überlappung kann mindestens 0,5 mm oder 1 mm bis 2 mm betragen, wobei bei einer Überlappung von 2 mm von einer sicher ausreichenden Überlappung ausgegangen werden kann. Die Beschichtung 30 überlappt auch einen Randbereich 28 des Kontaktfelds 22, und zwar umlaufend, so dass das Kontaktfeld 22 an seiner Oberseite 26 einen freien Zentralbereich 27 aufweist, der ohne Beschichtung 30 ist. Dies wird aus der Schnittdarstellung der Fig. 3 besonders gut deutlich. Der mit der Beschichtung 30 überdeckte Randbereich 28 soll umlaufend sein und nur den freien Zentralbereich 27 auf dem Kontaktfeld 22 freilassen. Die Kontaktbahn 20 selbst sollte auf alle Fälle vollständig überdeckt sein ohne einen freien Bereich. Der von der Beschichtung 30 freigelassene Ausschnitt 32 als freier Zentralbereich 27 kann dann zum Anlöten eines Anschlusses genutzt werden, wie nachfolgend noch näher erläutert wird. Aus der Schnittdarstellung der Fig. 3 ist zu erkennen, dass bis auf den freien Zentralbereich 27 innerhalb des Ausschnitts 32 eine sehr gute und sehr sichere Abdeckung oder Bedeckung des Kontaktfelds 22 durch die Beschichtung 30 gegeben ist.

Des Weiteren ist aus der Querschnittsdarstellung der Fig. 3 zu ersehen, dass die Beschichtung 30 im Randbereich 28 auch eine gewisse Höhe aufweist. Diese kann hier zwar übertrieben dargestellt sein und in der Praxis auch weniger oder sogar deutlich weniger als die Dicke bzw. Höhe des Kontaktfelds 22 selbst betragen. Zu den möglichen geometrischen Abmessungen wird auf die vorstehenden Ausführungen verwiesen. Jedenfalls wird so in dem Ausschnitt 32 eine seitliche Begrenzung und somit eine Art Becken gebildet, welches später beim Anlöten eines Anschlusses mit Lot und ggf. auch mit Flussmittel, vorteilhaft ausschließlich mit Lot, sozusagen volllaufen und gefüllt sein kann. So kann sichergestellt werden, dass das Lot auf der Oberseite 26, das an den Randbereich 28 sozusagen heranläuft oder anstößt, die gesamte Oberseite 26 bedeckt, und zwar auch mit einer gewissen ausreichenden Dicke. Hierzu wird nachfolgend noch mehr ausgeführt.

Aus der Draufsicht auf die gesamte Heizeinrichtung 11 als erfindungsgemäßes Schaltungsbauteil gemäß der Fig. 2 ist zu ersehen, dass der Träger 13 speziell geformt ist. Er ist hier flach ausgebildet und verläuft nach rechts weiter, und in diesem Bereich sind auch mehrere parallel zueinander verlaufende streifenförmige Heizleiter 18 vorgesehen. Diese bestehen aus einem üblichen Heizleitermaterial, vorteilhaft aufgebracht durch Siebdruckverfahren in einem Dickschichtverfahren, wie es aus dem Stand der Technik ausreichend bekannt ist. Der oberste Heizleiter 18 ist elektrisch kontaktiert mit einer Kontaktbahn 20a, die nach links zu auf einem linken Anschlussende 16 der Heizeinrichtung 11 verläuft und zu einem verbreiterten Kontaktfeld 22a geht. Zwischen Kontaktbahn 20a und Kontaktfeld 23a gibt es einen Übergangsbereich 23a, in dem die Breite allmählich größer wird. Das Kontaktfeld 22a ist ähnlich wie dasjenige aus Fig. 1 länglich ausgebildet und angenähert rechteckig. Es kann eine Länge von etwa 8 mm und eine Breite von etwa 4 mm aufweisen. In ähnlicher Form geht vom untersten Heizleiter 18 eine Kontaktbahn 20b ab und diese wiederum mit einem etwas anders ausgebildeten Übergangsbereich 23b an ein Kontaktfeld 22b. Dieses ist ausgebildet wie das Kontaktfeld 22a.

Die Kontaktfelder 22a und 22b dienen zum elektrischen Anschluss der Heizleiter 18 der Heizeinrichtung 11. Für Sensoren odgl. sind noch zwei weitere Kontaktfelder 22c und 22d vorgesehen, von denen etwas schmalere Kontaktbahnen 20d und 20c abgehen, welche ineinander übergehen. Im Verlauf sind zwei Unterbrechungen 24 ausgebildet, an denen beispielsweise Temperatursensoren in SMD-Bauweise aufgesetzt und angelötet werden können. Anders als bei den Kontaktfeldern 22a und 22b für die Heizleiter 18 fließen hier nur sehr geringe Ströme, deswegen sind an den Unterbrechungen 24 keine speziellen und vergrößerten Kontaktfelder notwendig. Sämtliche Kontaktfelder 22a bis 22d bei der Fig. 2 sind gleich groß, was aber nicht zwingend so sein muss.

Der Übergang zwischen Heizleiter 18 und Kontaktbahn 20a und 20b erfolgt wiederum über eine Art Kontaktfelder oder Überdruckungen, wie dies an sich aus dem Stand der Technik bekannt ist.

Die Heizeinrichtung 11 bzw. die Oberseite 14 von deren Träger 13 ist mit einer erfindungsgemäßen Beschichtung 30 überdeckt. Deswegen sind die genannten Komponenten unterhalb dieser Beschichtung 30 gestrichelt dargestellt. Die Beschichtung 30 ist vom Verlauf bzw. ihrer Kontur her so ausgebildet, dass sie die Komponenten vollständig überdeckt, beispielsweise auch entlang der Längsseiten der Heizleiter 18 2 mm bis 3 mm über diese überragt. Im Bereich der Kontaktfelder 22a, 22c und 22d sowie deren Kontaktbahnen 20a, 20c und 20d ist die Beschichtung 30 nach Art von länglichen Armen ausgebildet, um diese zwar zu überdecken, aber nicht zu weit zu überdecken bzw. nicht weiter als notwendig. So kann Material für die Beschichtung eingespart werden. Innerhalb der von der Beschichtung 30 bedeckten Fläche sind dann entsprechend Fig. 1 Ausschnitte für die Kontaktfelder 22a bis 22e sowie für die rechte Unterbrechung 24 vorgesehen. Für die linke Unterbrechung 24 ist von der Seite her quasi ein Einschnitt in die Beschichtung 30 vorgesehen, da sie hier sehr nahe am Rand liegt. Somit reicht eine Art seitlicher Einschnitt anstelle eines Ausschnitts.

In der Fig. 4 ist für eine etwas anders ausgebildete Heizeinrichtung 111 dargestellt, wie der Anschluss 134 auf einem Kontaktfeld 122 angelötet ist. Im Unterschied zur an sich ähnlichen Fig. 3 ist hier der Träger 113 aus einem elektrisch isolierenden Material hergestellt, beispielsweise aus Keramik. Bei der Fig. 3 kann der Träger 13 ein an sich übliches Stahlsubstrat sein, das mittels der darüber aufgebrachten Dielektrikumsschicht 15 an der Oberseite 14 elektrisch sicher isoliert ist.

Auf die Oberseite 114 des Trägers 113 ist ein Kontaktfeld 122 aufgebracht. Es besteht aus demselben Material wie zuvor beschrieben, ist also auch silberhaltig. Von diesem Kontaktfeld 122 geht eine nicht dargestellte Kontaktbahn ab, beispielsweise an Heizleiter der Heizeinrichtung 111. Auch hier ist der Querschnitt des Kontaktfelds 122 streng rechteckig ausgebildet und dargestellt, in der Praxis sind Außenseiten 122' vorteilhaft sowohl nach unten und nach außen abgerundet als auch nach oben und nach innen abgerundet ausgebildet. Die Höhe bzw. Dicke des Kontaktfelds 122 kann allgemein zwischen 10 µm und 150 µm liegen, vorteilhaft zwischen 15 µm und 50 µm liegen. Hier kann sie etwa 20 µm betragen. Die Breite des Kontaktfelds, die in Fig. 4 in Richtung von links nach rechts sichtbar ist, kann 4 mm betragen.

Bei der Herstellung der Heizeinrichtung 111 ist auf den Träger 113 im Bereich des Kontaktfelds 122 und nach dessen Aufbringen eine Beschichtung 130 aufgebracht, vorteilhaft in einem Dickschichtverfahren mittels Siebdruck. Die Beschichtung 130 ist elektrisch isolierend und weist einen hohen Glasanteil auf, siehe die vorstehenden Erläuterungen hierzu. Die Beschichtung 130 wird auch in einem einzigen Schritt aufgebracht, und zwar ähnlich wie in Fig. 2 in einem einzigen Schritt als im Wesentlichen durchgängige Beschichtung bzw. als zusammenhängende Fläche, wenngleich diese etwas kompliziert ausgebildet und ausgeformt ist. Die Beschichtung 130 verläuft mit einer Breite von etwa 1 mm links und rechts neben dem Kontaktfeld 122 auf der Oberseite 114 des Trägers 113. Gleichzeitig überlappt sie aber in den beiden seitlichen Randbereichen 128 auf die Oberseite 126 des Kontaktfelds 122. Somit sind sowohl dessen Außenseiten 122' von der Beschichtung 130 bedeckt, indem diese direkt daran anliegt, als auch diese Randbereiche 128 selber. Die Überlappung ist hier relativ gering und beträgt in der Praxis etwa 300 µm. Die Dicke der Beschichtung 130 sowohl auf der Oberseite 114 des Trägers 113 als auch auf der Oberseite 126 des Kontaktfelds 122 kann allgemein zwischen 10 µm und 150 µm liegen. Hier beträgt sie etwa 30 µm, liegt hier also im Bereich der Dicke des Kontaktfelds 122 selbst bzw. ist etwas dicker.

Aus der Fig. 4 ist zu ersehen, dass sie eine Art seitliche Begrenzung bzw. eine Art Wanne aufweist, da die Beschichtung 130 umlaufend entlang des Randbereichs 128 verläuft und einen Ausschnitt 132 über einem freien Zentralbereich 127 des Kontaktfelds 122 aufweist. In einem nachfolgenden Schritt wird wie bekannt Lot als Paste auf die freie Oberseite 126 des Kontaktfelds 122 im freien Zentralbereich 127 aufgebracht, beispielsweise als eine Art Klecks. Dann wird in einem wiederum nachfolgenden Schritt ein Anschluss 134 herangeführt, der ein einzelner Anschluss sein kann oder zu einem Gruppenstecker odgl. gehören kann, also mehrere Anschlüsse gleichzeitig. Vorteilhaft ist der Anschluss 134 als Metallfahne oder als Metallspitze ausgebildet. Er kann auch unter Umständen eine größere Dicke aufweisen als hier dargestellt. Dabei wird der Anschluss 134 sozusagen in die Paste aus Lot hineingedrückt. In einem nochmals nachfolgenden Schritt wird die Paste aus Lot erhitzt, beispielsweise in einem üblichen Ofen zum Löten sämtlicher Lötstellen der Heizeinrichtung 111. Dabei wird das pastöse Lot 136 flüssig und verteilt sich mit einer Form ähnlich wie in Fig. 4 dargestellt sowohl an den Anschluss 134 als auch auf die freie Oberseite 126 im freien Zentralbereich 127 des Kontaktfelds 122. Die Menge an Lot 136 und die Größe des freien Zentralbereichs 127 bzw. die Breite des Randbereichs 128 im Vergleich zur Breite des Kontaktfelds 122 sind so abzustimmen, dass bei einem genau definierten Prozess eine Ausbreitung des Lots 136 in etwa erfolgt wie hier dargestellt. Dies bedeutet, dass das Lot 136 sicher im Randbereich 128 bis an die Beschichtung 130 heranreichen muss, vorteilhaft dabei noch eine gewisse Mindestdicke aufweist, wie hier dargestellt ist, die etwa 10 µm bis 40 µm betragen sollte. Nur dann ist nämlich sichergestellt, dass das gesamte Kontaktfeld 122 nach außen hin bedeckt ist, und zwar entlang der Außenseiten 122' und auf den Randbereichen 128 von der Beschichtung 130, und im Übrigen von dem Lot 136.

In einer möglichen Ausgestaltung der Erfindung kann zwar vorgesehen sein, dass manche Bereiche der freien Oberfläche des freien Zentralbereichs 127 nicht von Lot 136 bedeckt sind, sondern von darin enthaltenem Flussmittel. Dies weist aber das mögliche Problem auf, dass die Bedeckung mit dem Flussmittel nicht so sicher erfolgt wie mit Lot, und des Weiteren das Flussmittel keine derart stabile und beständige Überdeckung des Kontaktfelds 122 sicherstellt wie das Lot 136 selbst, ebenso wie die Beschichtung 130.

Anhand der Fig. 4 ist auch leicht vorstellbar, dass die von der Beschichtung 130 überdeckten Randbereiche 128 des Kontaktfelds 122 breiter sind bzw. der Ausschnitt 132, der sozusagen freigelassen wird, und damit auch der freie Zentralbereich 127 erheblich schmaler sind. Gleichzeitig muss aber auch sichergestellt sein, dass eine gewisse Toleranz für das Ansetzen des Anschlusses 134 an die Oberseite 126 im freien Zentralbereich 127 gegeben ist, wo auch das aufgebrachte, aber noch nicht geschmolzene Lot ist.

Bei der Heizeinrichtung 11 der Fig. 2 wird an die Kontaktfelder 22a bis 22e ein nicht dargestellter Gruppenstecker angelötet, von dem entsprechende Anschlussbeine als Anschlüsse nach links und nach rechts abstehen. Ein Gehäuse des Gruppensteckers befindet sich somit zwischen den Kontaktfeldern 22a, 22c und 22d links und den Kontaktfeldern 22b und 22e rechts. Diese Anschlussbeine sind dabei jeweils gleichartig und gleich groß. Dies muss aber nicht so sein, es sind auch völlig unterschiedliche Anschlüsse vorstellbar.

Im Bereich der Unterbrechungen 24 sind zwar zugegebenermaßen Bereiche der Kontaktbahnen 20c und 20d wahrscheinlich frei und unbedeckt, auch nach dem Anlöten von vorgenannten Temperatursensoren odgl.. Aufgrund deren geringer Breite sowie geringer zu erwartender Stromstärken ist dies nicht schädlich für ein vorgenanntes Abwandern von Silberionen daraus. Ein gewisser Verlust an Leitfähigkeit wäre auch nicht störend. Aufgrund der geringen Breite der Kontaktbahnen 20c und 20d kann aber in der Praxis davon ausgegangen werden, dass diese vollständig von den anzulötenden Bauteilen und vor allem von dem geschmolzenen Lot bedeckt sind.

## Patentansprüche

1. Elektrisches Schaltungsbauteil (11) aufweisend:
- einen Träger (13, 113) mit einer Oberseite (14, 114),
- eine Kontaktbahn (20) und ein mit der Kontaktbahn (20) verbundenes Kontaktfeld (22, 122), die insbesondere einstückig miteinander verbunden sind und in einem Schritt hergestellt sind, die auf der Oberseite (14, 114) des Trägers (13, 113) angeordnet sind, wobei das Kontaktfeld (22, 122) eine Oberseite (26, 126) und lateral umgebende Außenseiten (22', 122') aufweist,
- eine Beschichtung (30, 130) auf der Oberseite (14, 114) des Träges, wobei die Beschichtung (30, 130) mindestens einen Teil der Oberseite (14, 114) des Trägers (13, 113) bedeckt,
wobei:
- die Beschichtung (30, 130) elektrisch isolierend ist,
- die Beschichtung (30, 130) Glas aufweist oder zu mindestens 50 % aus Glas besteht,
- die Beschichtung (30, 130) weitere Kontaktbahnen (20) und/oder Kontaktfelder (22, 122) auf der Oberseite (14, 114) des Trägers (13, 113) zumindest teilweise bedeckt,
- die Beschichtung (30, 130) temperaturbeständig und dabei inert ist bis Temperaturen bis mindestens 500°C,
**dadurch gekennzeichnet, dass**:
- die Beschichtung (30, 130) entlang aller Außenseiten (22', 122') des Kontaktfelds (22, 122) mindestens an das Kontaktfeld (22, 122) heranreicht und das Kontaktfeld (22, 122) zumindest an den Außenseiten (22', 122') vollständig bedeckt und einschließt.

2. Schaltungsbauteil nach Anspruch 1, wobei die Beschichtung (30, 130) mindestens entlang eines Teils einer Außenseite (22', 122') des Kontaktfelds (22, 122), insbesondere entlang aller Außenseiten (22', 122') des Kontaktfelds (22, 122), von außen auf die Oberseite (26, 126) des Kontaktfelds (22, 122) überlappt und die Oberseite (26, 126) zumindest teilweise bedeckt.

3. Schaltungsbauteil nach Anspruch 2, wobei ein mittlerer bzw. zentraler Bereich (27, 127) der Oberseite (26, 126) des Kontaktfelds (22, 122) frei bleibt und ohne Beschichtung (30, 130) ist, wobei vorzugsweise mindestens 30% der Oberseite (26, 126) des Kontaktfelds (22, 122) frei sind ohne Beschichtung (30, 130), vorzugsweise mindestens 70% bis zu maximal 95%.

4. Schaltungsbauteil nach einem der vorhergehenden Ansprüche, wobei die Beschichtung (30, 130) die Kontaktbahn (20) zumindest im Bereich des Übergangs (23) von der Kontaktbahn (20) an das Kontaktfeld (22, 122) bedeckt und im Bereich des Übergangs (23) der Kontaktbahn (20) an das Kontaktfeld (22, 122) auch die Oberseite (26, 126) des Kontaktfelds (22, 122) bedeckt, wobei vorzugsweise die Kontaktbahnen (20) zwischen mindestens zwei Kontaktfeldern (22, 122) verläuft und vollständig mit der Beschichtung (30, 130) bedeckt ist.

5. Schaltungsbauteil nach einem der vorhergehenden Ansprüche, wobei eine Beschichtung (30, 130) auf der Oberseite (26, 126) des Kontaktfelds (22, 122) umlaufend ist und alle Außenseiten (22', 122') oder Außenbereiche des Kontaktfelds (22, 122) bedeckt, insbesondere durchgehend auf die Oberseite (14, 114) des Trägers (13, 113) hinunter bedeckt.

6. Schaltungsbauteil nach einem der vorhergehenden Ansprüche, wobei eine Dicke der Beschichtung (30, 130), insbesondere in Richtung senkrecht zur Oberseite (26, 126) des Kontaktfelds (22, 122), mindestens 10% der Dicke des Kontaktfelds (22, 122) in derselben Richtung beträgt, insbesondere mindestens 30% bis zu 100 %.

7. Schaltungsbauteil nach einem der vorhergehenden Ansprüche, wobei die Beschichtung (30, 130) als einzige durchgehende Beschichtung (30, 130) ausgebildet ist.

8. Schaltungsbauteil nach einem der vorhergehenden Ansprüche, wobei die Beschichtung (30, 130) temperaturbeständig und dabei inert ist bis Temperaturen von mindestens 800°C.

9. Schaltungsbauteil nach einem der vorhergehenden Ansprüche, wobei die Beschichtung (30, 130) Bereiche der Oberseite (14, 114) des Trägers (13, 113), die ohne Aufbau sind und keine Bauteile oder Kontaktbahnen (20) tragen, frei lässt.

10. Schaltungsbauteil nach einem der vorhergehenden Ansprüche, wobei auf der Oberseite (14, 114) des Trägers (13, 113) Heizleiter (18) angeordnet sind, die als Beschichtung (30, 130) aufgebracht sind, insbesondere in Dickschichttechnik, wobei vorzugsweise die Heizleiter (18), insbesondere auch die Kontaktbahn (20), silberhaltig ist, wobei insbesondere auch die Heizleiter (18) von der Beschichtung (30, 130) bedeckt sind.

11. Schaltungsbauteil nach einem der vorhergehenden Ansprüche, wobei an der Oberseite (26, 126) des Kontaktfelds (22, 122) ein Anschluss (134) befestigt ist, insbesondere mit Lot (136) angelötet ist oder angeschweißt ist, wobei das Kontaktfeld (22, 122) vollständig bedeckt ist mit dem Anschluss (134), mit dem Lot (136) an der Oberseite (26, 126) und mit der Beschichtung (30, 130) entlang der Außenseiten (22', 122').

12. Schaltungsbauteil nach Anspruch 11, wobei die Beschichtung (30, 130) an die Außenseiten (22', 122') des Kontaktfelds (22, 122) angrenzend auf einen an die Außenseiten (22', 122') angrenzenden Randbereich (28, 128) auf der Oberseite (26, 126) des Kontaktfelds (22, 122) überlappt und diesen Randbereich (28, 128) bedeckt, wobei insbesondere der Randbereich (28, 128) auf der Oberseite (26, 126) mindestens 0,5 mm breit ist, vorzugsweise bis zu 2 mm breit ist.

13. Verfahren zur Herstellung eines Schaltungsbauteils (11) nach einem der vorhergehenden Ansprüche, **dadurch gekennzeichnet, dass**
- in einem vorausgehenden Schritt auf einer Oberseite (14, 114) des Trägers (13, 113) des Schaltungsbauteils (11) Kontaktbahnen (20) und damit verbundene Kontaktfelder (22, 122) aufgebracht werden und
- in einem nachfolgenden Schritt eine Beschichtung (30, 130) zumindest teilweise auf die Oberseite (14, 114) des Trägers (13, 113), zumindest teilweise auf die Kontaktbahn (20) und zumindest an die Außenseiten (22', 122') des Kontaktfelds (22, 122) aufgebracht wird.

14. Verfahren nach Anspruch 13, wobei die Beschichtung (30, 130) in einem einzigen Schritt aufgebracht wird, wobei insbesondere die Beschichtung (30, 130) durch ein Dickschichtverfahren aufgedruckt wird.

15. Verfahren nach Anspruch 13 oder 14, wobei die Beschichtung (30, 130) auch auf einen Randbereich (28, 128) der Oberseite (26, 126) des Kontaktfelds (22, 122) aufgebracht wird.

## Claims

1. Electrical circuit component (11) comprising:
- a carrier (13, 113) with an upper side (14, 114),
- a contact track (20) and a contact field (22, 122) connected to the contact track (20), which are in particular connected to each other in one piece and are manufactured in one step, which are arranged on the upper side (14, 114) of the carrier (13, 113), wherein the contact field (22, 122) having an upper side (26, 126) and laterally surrounding outer sides (22', 122'),
- a coating (30, 130) on the upper side (14, 114) of the carrier, wherein the coating (30, 130) covers at least part of the upper side (14, 114) of the carrier (13, 113),
wherein:
- the coating (30, 130) is electrically insulating,
- the coating (30, 130) comprises glass or consists of at least 50% glass,
- the coating (30, 130) at least partially covers further contact tracks (20) and/or contact fields (22, 122) on the upper side (14, 114) of the carrier (13, 113),
- the coating (30, 130) is temperature-resistant and inert up to temperatures of at least 500°C,
**characterised in that**:
- the coating (30, 130) extends along all outer sides (22', 122') of the contact field (22, 122) at least reaches the contact field (22, 122) and completely covers and encloses the contact field (22, 122) at least on the outer sides (22', 122').

2. Circuit component according to claim 1, wherein the coating (30, 130) extends at least along a portion of an outer side (22', 122') of the contact field (22, 122), in particular along all outer sides (22', 122') of the contact field (22, 122), overlaps the upper side (26, 126) of the contact field (22, 122) from the outside and at least partially covers the upper side (26, 126).

3. Circuit component according to claim 2, wherein a central area (27, 127) of the upper side (26, 126) of the contact field (22, 122) remains free and is without coating (30, 130), wherein preferably at least 30% of the upper side (26, 126) of the contact field (22, 122) is free of coating (30, 130), preferably at least 70% up to a maximum of 95%.

4. Circuit component according to one of the preceding claims, wherein the coating (30, 130) covers the contact track (20) at least in the area of the transition (23) from the contact track (20) to the contact field (22, 122) and, in the area of the transition (23) from the contact track (20) to the contact field (22, 122), also covers the upper side (26, 126) of the contact field (22, 122), wherein the contact tracks (20) preferably run between at least two contact fields (22, 122) and are completely covered by the coating (30, 130).

5. Circuit component according to one of the preceding claims, wherein a coating (30, 130) is circumferential on the upper side (26, 126) of the contact field (22, 122) and covers all outer sides (22', 122') or outer areas of the contact field (22, 122), in particular continuously down to the upper side (14, 114) of the carrier (13, 113).

6. Circuit component according to one of the preceding claims, wherein a thickness of the coating (30, 130), in particular in the direction perpendicular to the upper side (26, 126) of the contact field (22, 122), is at least 10% of the thickness of the contact field (22, 122) in the same direction, in particular at least 30% to 100%.

7. Circuit component according to one of the preceding claims, wherein the coating (30, 130) is formed as a single continuous coating (30, 130).

8. Circuit component according to one of the preceding claims, wherein the coating (30, 130) is temperature-resistant and inert up to temperatures of at least 800°C.

9. Circuit component according to one of the preceding claims, wherein the coating (30, 130) leaves areas of the upper side (14, 114) of the carrier (13, 113) free which are without structure and do not carry any components or contact tracks (20).

10. Circuit component according to one of the preceding claims, wherein heating conductors (18) are arranged on the upper side (14, 114) of the carrier (13, 113) heating conductors (18) are arranged on the upper side (14, 114) of the carrier (13, 113), which are applied as a coating (30, 130), in particular using thick-film technology, wherein the heating conductors (18), in particular also the contact track (20), preferably containing silver, wherein in particular the heating conductors (18) are also covered by the coating (30, 130).

11. Circuit component according to one of the preceding claims, wherein a connection (134) is attached to the upper side (26, 126) of the contact field (22, 122), in particular soldered or welded with solder (136), wherein the contact field (22, 122) is completely covered by the connection (134), by the solder (136) on the upper side (26, 126) and by the coating (30, 130) along the outer sides (22', 122').

12. Circuit component according to claim 11, wherein the coating (30, 130) is applied to the outer sides (22', 122') of the contact field (22, 122) adjacent to an edge area (28, 128) on the upper side (26, 126) of the contact field (22, 122) adjacent to the outer sides (22', 122') of the contact field (22, 122). 122') on the upper side (26, 126) of the contact field (22, 122) and covers this edge area (28, 128), wherein, in particular, the edge area (28, 128) on the upper side (26, 126) is at least 0.5 mm wide, preferably up to 2 mm wide.

13. Method for manufacturing a circuit component (11) according to one of the preceding claims, **characterised in that**
- in a preceding step, contact tracks (20) and associated contact fields (22, 122) are applied to an upper side (14, 114) of the carrier (13, 113) of the circuit component (11), and
- in a subsequent step, a coating (30, 130) is applied at least partially to the upper side (14, 114) of the carrier (13, 113), at least partially on the contact track (20) and at least on the outer sides (22', 122') of the contact field (22, 122).

14. Method according to claim 13, wherein the coating (30, 130) is applied in a single step, wherein in particular the coating (30, 130) is printed by a thick-film process.

15. Method according to claim 13 or 14, wherein the coating (30, 130) is also applied to an edge area (28, 128) of the upper side (26, 126) of the contact field (22, 122).

## Revendications

1. Composant de circuit électrique (11) comprenant :
- un support (13, 113) avec une face supérieure (14, 114),
- une piste de contact (20) et une zone de contact (22, 122) reliée à la piste de contact (20), qui sont notamment reliées entre elles d'un seul tenant et sont fabriquées en une seule étape, qui sont disposées sur la face supérieure (14, 114) du support (13, 113), la zone de contact (22, 122) présentant une face supérieure (26, 126) et des faces latérales (22', 122') qui l'entourent latéralement,
- un revêtement (30, 130) sur la face supérieure (14, 114) du support, le revêtement (30, 130) recouvrant au moins une partie de la face supérieure (14, 114) du support (13, 113),
dans lequel:
- le revêtement (30, 130) est électriquement isolant,
- le revêtement (30, 130) comprend du verre ou est composé d'au moins 50 % de verre,
- le revêtement (30, 130) recouvre au moins partiellement d'autres pistes de contact (20) et/ou zones de contact (22, 122) sur la face supérieure (14, 114) du support (13, 113),
- le revêtement (30, 130) est résistant à la température et inerte jusqu'à des températures d'au moins 500 °C,
**caractérisé en ce que** :
- le revêtement (30, 130) s'étend le long de tous les faces latérales (22', 122') de la zone de contact (22, 122) s'étend au moins jusqu'à la zone de contact (22, 122) et recouvre et englobe complètement la zone de contact (22, 122) au moins sur les faces latérales (22', 122').

2. Composant de circuit selon la revendication 1, dans lequel le revêtement (30, 130) s'étend au moins le long d'une partie d'une face latéral (22', 122') de la zone de contact (22, 122), en particulier le long de tous les faces latérales (22', 122') de la zone de contact (22, 122), depuis l'extérieur sur la face supérieure (26, 126) de la zone de contact (22, 122) et recouvre au moins partiellement la face supérieure (26, 126).

3. Composant de circuit selon la revendication 2, dans lequel une zone centrale (27, 127) de la face supérieure (26, 126) de la zone de contact (22, 122) reste libre et est dépourvue de revêtement (30, 130), de préférence au moins 30 % de la face supérieure (26, 126) de la zone de contact (22, 122) est libre, sans revêtement (30, 130), de préférence au moins 70 % jusqu'à 95 % au maximum.

4. Composant de circuit selon l'une des revendications précédentes, le revêtement (30, 130) recouvrant la piste de contact (20) au moins dans la zone de transition (23) entre la piste de contact (20) et la zone de contact (22, 122) et, dans la zone de transition (23) de la piste de contact (20) vers la zone de contact (22, 122), recouvre également la face supérieure (26, 126) de la zone de contact (22, 122), les pistes de contact (20) s'étendant de préférence entre au moins deux zones de contact (22, 122) et étant entièrement recouvertes par le revêtement (30, 130).

5. Composant de circuit selon l'une des revendications précédentes, dans lequel un revêtement (30, 130) recouvre toute la surface supérieure (26, 126) de la zone de contact (22, 122) et recouvre toutes les faces latérales (22', 122') ou les zones extérieures de la zone de contact (22, 122), en particulier de manière continue jusqu'à la face supérieure (14, 114) du support (13, 113).

6. Composant de circuit selon l'une des revendications précédentes, dans lequel l'épaisseur du revêtement (30, 130), en particulier dans la direction perpendiculaire à la face supérieure (26, 126) de la zone de contact (22, 122), est d'au moins 10 % de l'épaisseur de la zone de contact (22, 122) dans la même direction, en particulier d'au moins 30 % à 100 %.

7. Composant de circuit selon l'une des revendications précédentes, le revêtement (30, 130) étant conçu comme un revêtement continu unique (30, 130).

8. Composant de circuit selon l'une des revendications précédentes, dans lequel le revêtement (30, 130) est résistant à la température et inerte jusqu'à des températures d'au moins 800 °C.

9. Composant de circuit selon l'une des revendications précédentes, dans lequel le revêtement (30, 130) laisse libres les zones de la face supérieure (14, 114) du support (13, 113) qui ne comportent pas de structure et ne portent pas de composants ou de pistes de contact (20).

10. Composant de circuit selon l'une des revendications précédentes, dans lequel sont disposés sur la face supérieure (14, 114) du support (13, 113) des conducteurs chauffants (18) qui sont appliqués sous forme de revêtement (30, 130), en particulier selon la technique des couches épaisses, les conducteurs chauffants (18), en particulier également la piste de contact (20), contiennent de l'argent, les conducteurs chauffants (18) étant également recouverts par le revêtement (30, 130).

11. Composant de circuit selon l'une des revendications précédentes, dans lequel un raccord (134) est fixé sur la face supérieure (26, 126) de la zone de contact (22, 122), en particulier soudé à la brasure (136) ou soudé, la zone de contact (22, 122) est entièrement recouvert par la connexion (134), par la soudure (136) sur la face supérieure (26, 126) et par le revêtement (30, 130) le long des faces latérales (22', 122').

12. Composant de circuit selon la revendication 11, dans lequel le revêtement (30, 130) est adjacent aux faces latérales (22', 122') de la zone de contact (22, 122) sur une zone de bordure (28, 128) adjacente aux faces latérales (22', 122') sur la face supérieure (26, 126) de la zone de contact (22, 122) et recouvre cette zone de bordure (28, 128), la zone de bordure (28, 128) sur la face supérieure (26, 126) a une largeur d'au moins 0,5 mm, de préférence jusqu'à 2 mm.

13. Procédé de fabrication d'un composant de circuit (11) selon l'une des revendications précédentes, **caractérisé en ce que**
- dans une étape préalable, des pistes de contact (20) et des zones de contact (22, 122) qui leur sont associés sont appliqués sur une face supérieure (14, 114) du support (13, 113) du composant de circuit (11) et
- dans une étape suivante, un revêtement (30, 130) est appliqué au moins partiellement sur la face supérieure (14, 114) du support (13, 113), au moins partiellement sur la piste de contact (20) et au moins sur les faces latérales (22', 122') de la zone de contact (22, 122).

14. Procédé selon la revendication 13, dans lequel le revêtement (30, 130) est appliqué en une seule étape, le revêtement (30, 130) étant notamment imprimé par un procédé à couche épaisse.

15. Procédé selon la revendication 13 ou 14, dans lequel le revêtement (30, 130) est également appliqué sur une zone de bordure (28, 128) de la face supérieure (26, 126) de la zone de contact (22, 122).
